# EUROPEAN PATENT SPECIFICATION

(11) **EP 2 945 198 B1**
(45) Date of publication and mention of the grant of the patent: **18.10.2017**
(21) Application number: 15167285.4
(22) Date of filing: 12.05.2015
(51) Int. Cl.: H01L 35/30, F25B 21/02

(54) **HEAT CONVERSION DEVICE**
WÄRMEUMWANDLUNGSVORRICHTUNG
DISPOSITIF DE CONVERSION DE CHALEUR

(30) Priority: 13.05.2014 KR 20140057407
(43) Date of publication of application: 18.11.2015
(73) Proprietor: LG Innotek Co., Ltd., Seoul, 04637 (KR)
(72) Inventor: Shin, Jong Bae, 100-714 SEOUL (KR); Cho, Yong Sang, 100-714 SEOUL (KR)
(74) Representative: Novagraaf Technologies

(56) References cited:
- EP-A1- 2 453 182
- JP-A- H0 680 016
- JP-A- 2001 108 328
- JP-A- 2008 232 565
- JP-A- 2013 089 821

## Description

### BACKGROUND OF THE INVENTION

### Field of the Invention

Embodiments of the present invention relate to a heat conversion device including a thermoelectric element.

### Description of the Related Arts

In general, a thermoelectric element including a thermoelectric conversion element is configured such that a P-type thermoelectric material and an N-type thermoelectric material are bonded between metal electrodes to form a PN bonding pair. When a temperature difference is applied to the PN bonding pair, electric power is produced by a Seebeck effect so that the thermoelectric element can serve as a power generation device. Furthermore, the thermoelectric element may be used as a temperature control device by a Peltier effect that one of the PN bonding pair is cooled and another one thereof is heated.

In such a case, as a radiating member is formed on a heat emitting part and a heat absorbing part, the thermoelectric element may be applied as a device that can dehumidify and dry inflowing air. However, even though the air flowing into the heat absorbing part from a thermoelectric module is primarily dehumidified, and thereafter, the air is introduced to the heat emitting part disposed at an upper portion of the thermoelectric element and is dried, it is problematic in that dehumidifying efficiency is reduced because flow of the air is increased, and thus a resistance to the flow is generated. Even though there is a way intended for solving this problem by increasing the intensity of the inflowing air and entirely making the flow of air strong, since this way results in an increase in power consumption and an increase in noise, it is problematic in that performance of the thermoelectric element as a dehumidifier is reduced.

Also, when the thermoelectric element is applied as a device capable of dehumidifying and drying inflowing air by forming a radiating member on a heat emitting part and a heat absorbing part, humid air is entered, and thus when the air passes through a heat sink, the air has low humidity and temperature. Accordingly, when the device is used in a closed space, since a temperature is increased, the device has a limit in using it.

JP2001108328 describes a heat exchanger with three heat exchanging units arranged in series, each unit being controllable and using Peltier elements.

### SUMMARY OF THE INVENTION

The present invention has been made keeping in mind the above problems, and an aspect of embodiments of the present invention provides a heat conversion device capable of performing the processes for condensing, drying, and re-condensing inflowing air with regard to a structure of a heat exchanger to which a thermoelectric module is applied, so that a temperature of the dried air can be controlled again, and the air can be discharged in a state of being maintained at a desired temperature.

The invention is defined by the claim. According to an aspect of the embodiments of the present invention, a heat conversion device may include: a thermoelectric module including a thermoelectric semiconductor between substrates facing each other; a first module converting a temperature of inflowing air using a heat conversion function of the thermoelectric module; a second module reconverting the temperature of the air passing through the first module ; and a third module controlling the temperature of the air passing through the second module.

### BRIEF DESCRIPTION OF THE DRAWINGS

The accompanying drawings are included to provide a further understanding of the present invention, and are incorporated in and constitute a part of this specification. The drawings illustrate exemplary embodiments of the present invention and, together with the description, serve to explain principles of the present invention. In the drawings:
FIG. 1 illustrates a perspective conceptual view of a heat conversion device according to an embodiment of the present invention;
FIG. 2 illustrates a cross-sectional view of the heat conversion device taken along line W-W' of FIG. 1;
FIG. 3 illustrates one example of the structure of a heat conversion member included in a heat conversion module according to an embodiment of the present invention;
FIG. 4 is an enlarged conceptual view showing a structure formed by one flow path pattern in the heat conversion member;
FIG. 5 is a partially enlarged view of the flow path pattern of FIG. 4;
FIG. 6 is a conceptual view variously illustrating an implementation example of the flow path pattern of the heat transmission member;
FIG. 7 is a conceptual view showing a flat arrangement of a thermoelectric module;
FIG. 8 a structure of a unit cell of the thermoelectric module including a thermoelectric element in contact with a first module and a second module in the embodiment of the present invention; and
FIG. 9 illustrates the thermoelectric module in which the structure of FIG. 8 is disposed in plural number.

### DETAILED DESCRIPTION OF THE INVENTION

Hereinafter, the configurations and operations according to embodiments of the present invention will be described in detail with reference to the accompanying drawings. The present invention may, however, be embodied in different forms and should not be construed as limited to the embodiments set forth herein. In the explanation with reference to the accompanying drawings, regardless of reference numerals of the drawings, like numbers refer to like elements through the specification, and repeated explanation thereon is omitted. Terms such as a first term and a second term may be used for explaining various constitutive elements, but the constitutive elements should not be limited to these terms. These terms are only used for the purpose for distinguishing a constitutive element from other constitutive element. As used herein, the singular forms "a," "an" and "the" are intended to include the plural forms as well, unless the context clearly indicates otherwise.

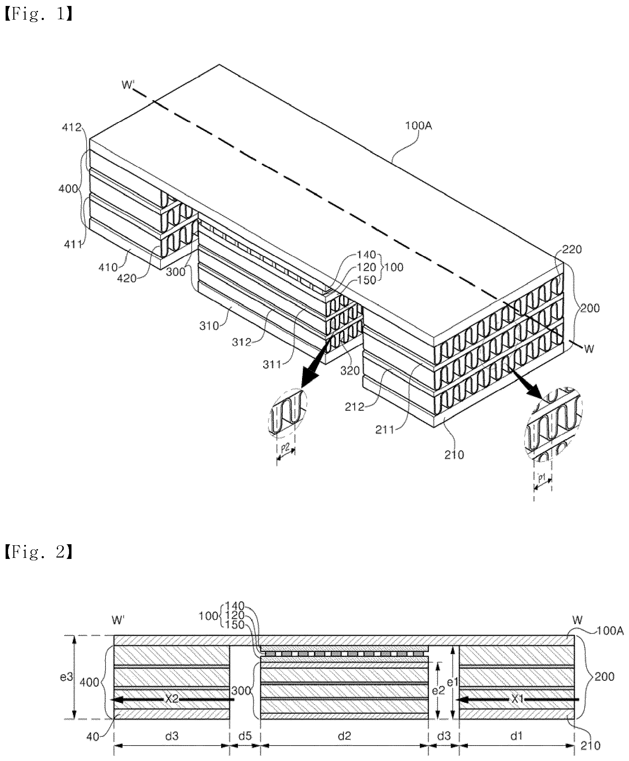

FIG. 1 illustrates a perspective conceptual view of a heat conversion device according to an embodiment of the present invention, and FIG. 2 illustrates a cross-sectional view of the heat conversion device taken along line W-W' of FIG. 1.

Referring to FIGS. 1 and 2, a heat conversion device according to an embodiment of the present invention may include: a thermoelectric module 100 including a thermoelectric semiconductor between substrates facing each other; a first module 200 converting a temperature of inflowing air using a heat conversion function of the thermoelectric module 100; a second module 300 reconverting the temperature of the air passing through the first module; and a third module 400 controlling the temperature of the air passing through the second module. Thanks to this configuration, when the first module and the third module are implemented as cooling modules, and the second module is implemented as a drying module, the heat conversion device according to the embodiment of the present invention primarily performs cooling and condensing with regard to first inflowing air, and thereafter, secondarily dries the air by drying and heating, and tertiarily cools the air having a high temperature so that the air can be controlled and discharged at a desired temperature. Of course, such an arrangement of the thermoelectric module may be changed and executed to cause drying-cooling-drying in addition to cooling-drying-cooling. However, in the present embodiment, the functions of the heat conversion device of the present invention will be described based on an example of the thermoelectric module in which the drying module is disposed in a central portion and the cooling modules are disposed at both sides.

The thermoelectric module 100 is configured such that thermoelectric semiconductor elements 120 electrically connected to each other are disposed between a pair of substrates 140, 150. The thermoelectric semiconductor elements are configured such that a P-type semiconductor and an N-type semiconductor are disposed to make a pair, and a heat absorbing part and a heat emitting part are implemented on the pair of substrates by the Peltier effect when an electric current is applied. The present embodiment of the invention shows an example in which, in the structure of FIGS. 1 and 2, a heat absorbing region is formed on a side of the first substrate 140, and a heat emitting region is formed on a side of the second substrate 150.

Moreover, the first module 200, the second module 300, and the third module 400, which perform a heat converting function with respect to air, may be disposed to be adjacent to any one of the first substrate 140 and the second substrate 150 of the thermoelectric module.

Also, in the illustrated structure in which a heat emitting effect and a heat absorbing effect of the thermoelectric module be received, the first module 200, the second module 300, and the third module 400 may be configured such that separate heat conversion members 220, 320, 420 are received inside separate receiving members, and the surface of the first substrate 140 or the second substrate 150 of the thermoelectric module 100 comes into contact with a surface of each receiving member. However, this is only an example. In addition to the structure in which the first module 200 and the third module 400 come into contact with each other by extending an intermediate member 100A in contact with the first substrate 120, a structure in which the first module 200 and the third module 400 come into contact with each other by extending the first substrate 120 itself may be also implemented. As such, the structure in which the first module and the second module come into direct contact with a surface of the first substrate 140 and a surface of the second substrate 150 enables direct transmission of a heat emitting operation and a heat absorbing operation of the thermoelectric module. Thus, it is advantageous in that heat transmission efficiency is increased, and stability of the device itself is increased with regard to the structure in which the intermediate member is interposed.

Also, the heat conversion device according to the present embodiment of the invention may include the heat conversion members 220, 320, 420 received in the first module, the second module and the third module, respectively and intended for performing heat conversion by coming into contact with the first substrate 140 and the second substrate 150, and various radiating members or structures such as a heat absorbing member and the like may be applied as the heat conversion members. In particular, in the present embodiment of the invention, the heat conversion members may be implemented to have contact surfaces with air, a liquid, and the like and to have flow path grooves capable of maximizing contact areas.

Like the structure illustrated in FIGS. 1 and 2, the thermoelectric module 100 is provided with the structure in which the first substrate 140 and the second substrate are included. In particular, a region in which the first substrate 140 is disposed is defined as a first heat conversion part as a region performing a heat absorbing function, and a region in which the second substrate 150 is disposed is defined as a second heat conversion part as a region performing a heat emitting function. The first and second heat conversion parts may enable the heat absorbing function and the heat emitting function to be implemented by the function of the thermoelectric element 120 and may further include an electrode, a dielectric, and the like, as well as the first substrate and the second substrate. The description thereof will be performed later.

The first module 200 and the third module 400 according to the present embodiment of the invention may be implemented to come in contact with the first heat conversion part of the thermoelectric module 100. In particular, such a contact may be implemented by disposing the intermediate member 100A so that the heat absorbing function of the first substrate 140 of the first heat conversion part can be transmitted.

Also, the second module 300 may be disposed to come into contact with the second heat conversion part. In particular, the second module may be implemented to come into contact with the second substrate 150 of the thermoelectric module 100 so that the heat emitting function can be transmitted.

In particular, in the embodiment of the present invention, it is more preferable to dispose the first module, the second module, and the third module in one side direction based on the thermoelectric module 100. In this case, as shown in FIGS. 1 and 2, like the structure in which the thermoelectric module 100, the first module 200, the second module 300, and the third module 400 are disposed in a horizontal direction, the arrangement in one side direction means any one direction of an upwards direction and a downwards direction based on the thermoelectric module. For example, one example of the present invention, the second module 300 may be disposed at a lower portion of the thermoelectric module 100, and the first module 200 and the third module 400 may be disposed so that an air flow path can be formed in a direction horizontal to the second module. It is advantageous in that such a structure can minimized resistance to the flow path and can increase thermoelectric efficiency by allowing the air flow path in the same space to pass through the module sequentially performing a heat absorbing function and a heat emitting function.

The heat transmission members 220, 320, 420 for implementing heat conversion by receiving a heat emitting function and the heat absorbing function are further included in the first module 200, the second module 300, and the third module, respectively, so that the air can be dried and cooled.

The first module 200, the second module 300, and the third module 400 may further include the heat transmission members 220, 320, 420 performing heat conversion by receiving the heat emitting and absorbing functions, respectively so that air can be dried and cooled. The heat transmission members 220, 320, 420 have separates heat transmission member receiving units 210, 310, 410, respectively, so that one or more heat transmission members can be laminated in each heat transmission member receiving unit, and may be implemented such that the remaining portions except for the air flow path are sealed. In the embodiment of FIGS. 1 and 2, when the plurality of heat transmission members is laminated, separate intermediate members 211, 311, 312, 411, 412 may be disposed between the respective heat transmission members. Moreover, even though it has not been described, when an upper portion of the first module 200 comes into contact with the intermediate member 100A, the intermediate member 100A comes into direct contact with the uppermost heat transmission member without being limited thereto. As described above, the heat transmission members may be received in the separate heat transmission receiving members.

In the structure illustrated in FIG. 1, the intermediate member 100A of the first module 200 comes into contact with the first substrate 140 from which a heat absorbing reaction is generated so that the first module 200 can perform a heat absorbing function, namely, a function of reducing a temperature. Accordingly, when external air entered from an external fan flows in the first module 200, the inflowing air comes into the first module 200 and the first heat conversion member 220 in the first module via the first substrate 140 of the thermoelectric module 100, and as a result, a temperature of the air is reduced so that moisture of the humid air can be condensed.

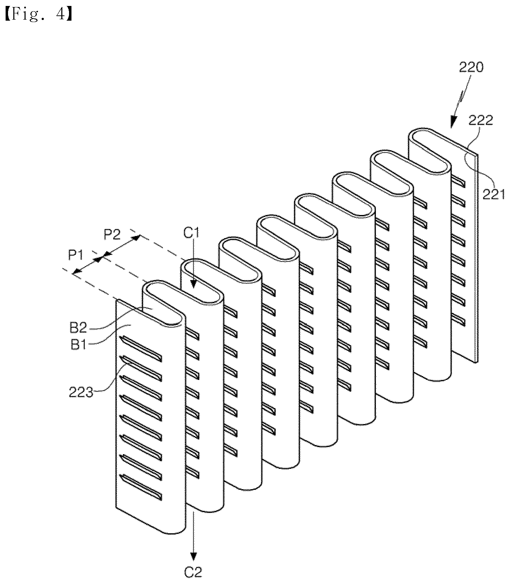

To do so, the first module 200 may maintain a low temperature in such a manner that a low temperature is induced to the first substrate due to a heat absorbing reaction, and the low temperature of the first substrate is transmitted to the first heat conversion member 220 of the first module 200 and the first heat conversion member receiving unit via the intermediate member 100A. In particular, in the embodiment of the present invention, the first heat transmission member 220 may be implemented in a structure in which characteristic flow path patterns are formed, so that a contact area with air can be maximized (see FIG. 4). Moreover, in the structure illustrated in FIG. 1, it is illustrated that the intermediate member 100A and the first substrate 140 are formed as separate structures. However, in order to further simplify the structure and enable efficient heat transmission, the first substrate 140 and the intermediate member 100A may be also implemented in an integral structure.

After moisture included in cooled air passing through an inner portion of the first module has been condensed and discharged, the second module 300 may introduce air and may include the second heat transmission member receiving unit 310 in contact with the second substrate forming a heat emitting region (the second heat conversion part) of the thermoelectric module 100. The second module may function to transmit the heat resulting from a heat emitting reaction of the second module due to surface contact with the second substrate into the second heat transmission member and the second heat transmission member receiving unit 310, and to enable air passing through the first module to be converted into dried air with the heat. Moreover, in such a case, a separate intermediate member may be further included between the second heat transmission member 320 and the second substrate 150. Of course, in this case, even though the intermediate member and the second substrate 150 may be formed as separate structures, in order to further simplify the structure and to enable efficient heat transmission, the intermediate member and the second substrate may be also implemented in an integral structure.

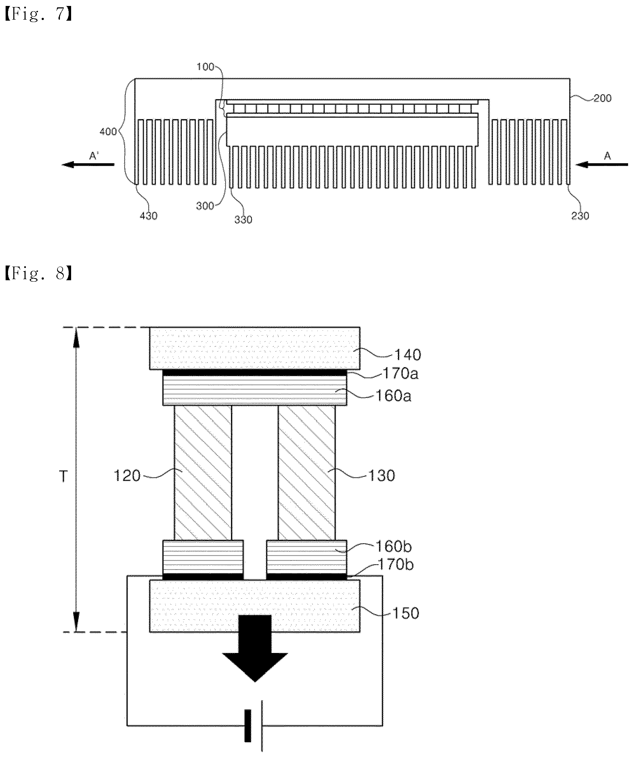

The third module 400 has the same structure as that of the first module 200 and comes into contact with the intermediate member 100A, thereby functioning to cool air again dried and heated by passing through the second module 300. Accordingly, the air passing through the third module may be finally converted into air having low humidity and low temperature and may be discharged. The configuration of the third module 400 may be formed to be identical to that of the first module 200. Of course, by changing the configuration of the heat transmission member, the heat conversion module having a structure presented in FIG. 7 may be disposed.

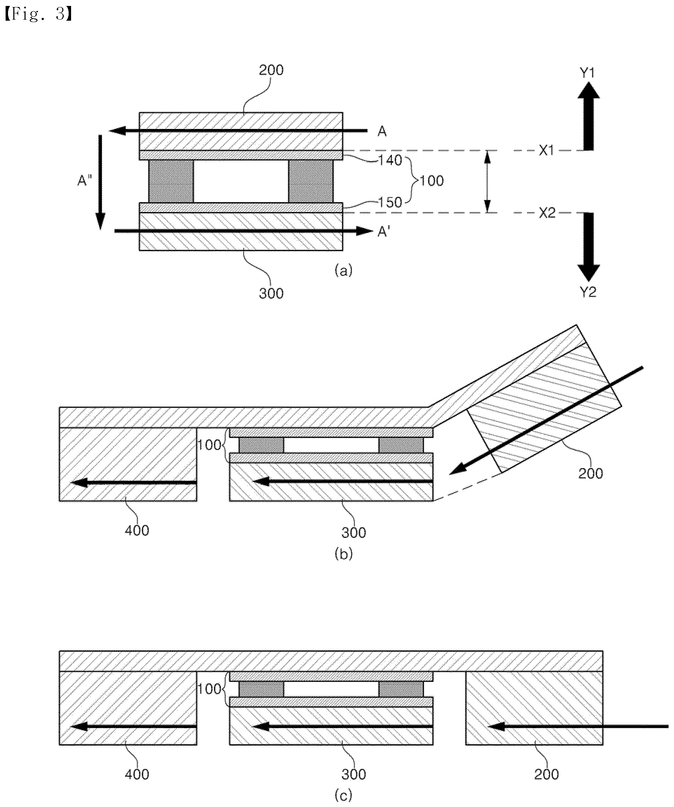

FIG. 3 is a conceptual view illustrated for explaining an example of an arrangement structure of the first module 200, the second module 300, and the third module 400 according to the embodiment of the present invention described in the sections regarding FIGS. 1 and 2.

As previously described, the first module 200, the second module 300, and the third module 400 according to the embodiment of the present invention may be disposed in 'one side direction' based on the thermoelectric module 100. In this case, the 'one side direction' means any one direction of an upwards direction Y1 and a downwards direction Y2 based on the thermoelectric module 100. That is, in consideration of an extension line X1 on an upper plane and an extension line X2 on a lower plane of the first substrate 140 of the thermoelectric module 100, any one of the first module, the second module, and the third module is disposed in a direction at which such a module comes into direct contact with the thermoelectric module, and another module is disposed in a direction horizontal to the direction. For example, as described in the sections regarding FIGS. 1 and 2, the second module 300 may be disposed at a lower part of the thermoelectric module 100, and the first module 200 and the third module 400 may be disposed so that an air flow path can be formed in a direction horizontal to the second module.

However, the arrangement structure of the first module, the second module, and the third module is not limited to the arrangement structure in the horizontal direction. As illustrated in (b) of IFG. 3, based on the first substrate of the thermoelectric module 100, any one of the first module 200 and the third module 400 may be disposed to be regularly inclined. If an arrangement structure enables the air to flow from the first module to the second module and from the second module to the third module without causing resistance to an air flow path according to a bending state of the air flow path through which the air passing through the first module and the second module travels, all arrangement structures in the form of such an arrangement structure may be included in the arrangement structure of the present invention in one side direction.

That is, 'the arrangement in the horizontal direction' in the form of 'the arrangement structure in the one side direction' defined in the embodiment of the present invention may cover all arrangement structures that enable external air primarily passing through the first module, namely, any or all of the air discharged by passing through the first module, to flow into the second module, and enable the air passing through the second module to flow into the third module. Accordingly, within the scope of the arrangement structures, the arrangement of the first module, the second module, and the third module may be modified in any form, and the modified arrangement structures may be also included in the gist of the present invention.

That is, except for a bidirectional arrangement structure in which the modules are disposed to be in close contact with an upper portion and a lower portion based on the thermoelectric module as shown in (a) of FIG. 3, namely, the arrangement structure of the first module 200 arranged at an upper part of the thermoelectric module 100 and the second module 300 arranged at a lower part of the thermoelectric module 100, all arrangement structures in which, as shown in (b) and (c) of FIG. 3, the first module 200 and the third module except for the second module 300 in contact with the thermoelectric module come into contact with the first substrate 140 and extend in an external side direction rather than a upwards direction to be disposed in a direction at which the second module 300 is disposed may be included in the embodiment of the present invention.

In the structure of (a) of FIG. 3, the inflowing air A is cooled while passing through the first module 200, moisture in the air is condensed. After the air has passed through the first module, the air travels to an air flow path bent in a "U"-like shape and flows into the second module 300 disposed in the downwards direction of the thermoelectric module so as to be dried by the heat emitting function. At this time, since serious resistance to the flow path is generated from the bent region, a dehumidification effect is reduced. Accordingly, in preferred embodiments of the present invention, the air flow path bent in the "U"-like shape is not formed, and the first module, the second module, and the third module are disposed in a direction horizontal to the air flow path so that resistance to the air flow path can be minimized.

FIGS. 4 to 6 are conceptual views illustrated for explaining a structure of the first heat transmission member 220, the second heat transmission member 320, and the third heat transmission member 420 received in the first module, the second module, and the third module, respectively, (wherein the structure will be described based on the first heat transmission member 220).

Referring to FIGS. 1, 4, and 5, the first heat transmission member 220 according to the embodiment of the present invention may be formed in a structure in which at least one flow path pattern 220A forming an air flow path C1 corresponding a fixed movement path of air is formed on a substrate having a flat plate-like shape and including a first plane 221, and a second plane 222 opposite to the first plane 221 so that a surface contact with the air can be performed.

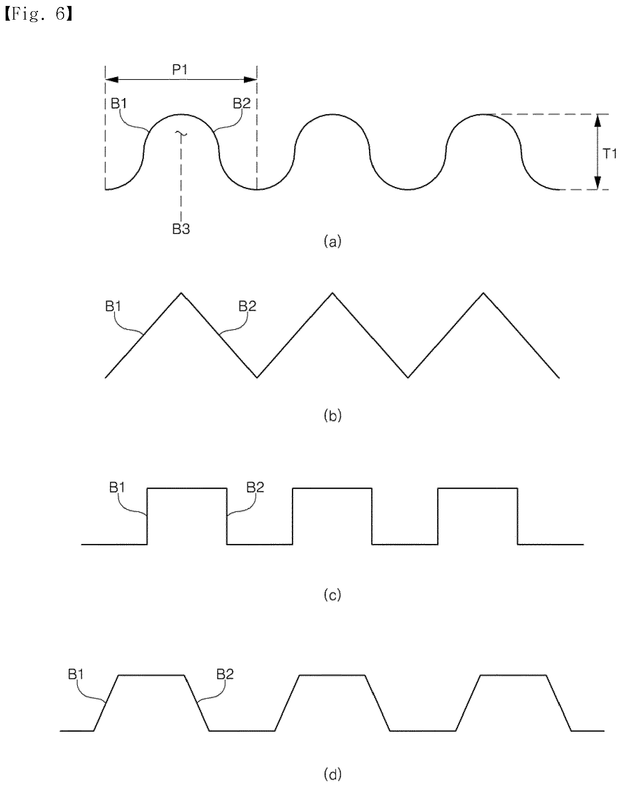

As illustrated in FIGS. 4 and 6, the flow path pattern 220A may be implemented such that a substrate is formed in a folding structure so that curvature patterns having a constant pitch P1, P2 and height T1 can be formed. The flow path pattern may be formed in variously modified shapes as illustrated in FIG. 6, as well as the structure illustrated in FIG. 4. That is, the first heat transmission member 220 or the second heat transmission member 320 according to the embodiment of the present may have two planes in a surface contact with air and may be implemented in a structure in which the flow path pattern is formed for maximizing a surface area in contact with the air. In the structure illustrated in FIG. 4, when the air is entered from a flow path direction C1 of an inflowing part into which the air flows, the air uniformly comes into contact with the first plane 221 and the second plane 222 opposite to the first plane so as to travel in an end direction of the flow path C2. Thus, such a structure may ensure a larger contact area with the air in the same space than a contact area generated from a simple flat plate-like shape so that the heat absorbing effect or the heat emitting effect can be improved.

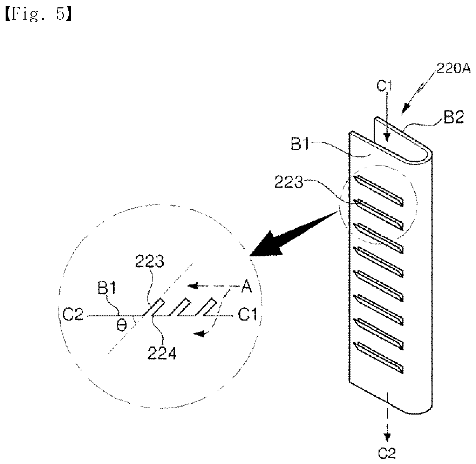

In particular, in order to increase a contact area with the air, as illustrated in FIGS. 4 and 5, the first heat transmission member 220 according to the embodiment of the present invention may include a protruding resistance pattern 223 on a surface of the substrate. In consideration of unit flow path patterns, the resistant pattern 223 may be formed on a first curved surface B1 and a second curved surface B2.

Furthermore, as shown in the partially enlarged view of FIG. 5, the resistance pattern 223 is formed as a protruding structure inclined to have a fixed inclination angle so that friction with the air can be maximized, thereby increasing a contact area or contact efficiency. Also, a groove 224 (hereinafter referred to as 'the flow path groove 224") is formed on the surface of the substrate at the front of the resistance pattern 223 so that part of the air in contact with the resistance pattern 223 can pass through a front surface and a rear surface of the substrate via the groove, thereby enabling an increase in a contact frequency or area. Also, in the example illustrated in FIG. 5, the resistance patterns are disposed so that resistance can be maximized at a flowing direction of the air, but are not limited thereto. The protruding direction of the resistance patterns may be designed in reverse so that a resistance level can be adjusted according to a resistance design. In FIG. 5, even though the resistance patterns 223 are formed on the external surface of the heat transmission member, in reverse, the resistance patterns may be formed on an internal surface of the heat transmission member.

FIG. 6 is a conceptual view variously illustrating an implementation example of the respective flow path patterns of the first heat transmission member, the second heat transmission member, and the third heat transmission member.

As illustrated in FIG. 6, (A) the pattern having a curvature with a fixed pitch P1 may be repeatedly formed, (B) unit patterns of the flow path pattern may be implemented in a repeated pattern structure having a triangular form, or as illustrated in (C) and (D), the unit patterns may be variously changed so as to have each cross section having a polygonal structure. Of course, the flow path pattern may be configured such that the resistance patterns described in the sections of FIG. 5 are provided on surfaces B1, B2 of the flow path pattern.

The flow path pattern illustrated in FIG. 6 is formed to have a fixed pitch and cycle. However, unlike this, the pitches of the unit patterns may not be uniform, and the cycles of the patterns may be modified to be non-uniform. Furthermore, the height T1 of each unit pattern may be also modified to be non-uniform.

Also, with regard to each structure of the first heat transmission member, the second heat transmission member, and the third heat transmission member, the respective pitches of the flow path patterns of the first heat transmission member, the second heat transmission member, and the third heat transmission member included in the first module 200, the second module 300, and the third module 400, respectively, may be adjusted to be different from each other, or the pitches of the flow path patterns of the first and third heat transmission member, and the pitch of the flow path pattern of the second transmission member may be adjusted to be different from each other in consideration of the heat conversion device according to the embodiment of the present invention illustrated in FIGS. 1 and 2.

In particular, the pitch of the flow path pattern of the first heat conversion member may be formed larger than the pitch of the flow path pattern of the second heat conversion member.

Specifically, a ratio (P1: P2) of the pitch P1 of the first heat transmission member 220 of the first module 200 to the pitch P2 of the second heat transmission member 320 of the second module 300 may range from 1∼1.4:1. Also, the pitch of the third heat transmission member 420 may be formed to be identical to that of the first heat transmission member.

Each structure of the heat transmission members according to the embodiment of the present invention, which form the flow patterns in FIGS. 4 and 5, may implement a larger contact area in the same volume than that generated from the heat transmission member having a flat plate-like structure or the existing radiating pin-like structure. This structure may result in an increase of the contact area with air up to 50% or more compared to the heat transmission member having the flat plate-like structure. Accordingly, a size of the module can be also largely reduced. In consideration of the condensing efficiency of initially inflowing humid air the drying efficiency of air using radiating after removal of moisture, a ratio of the pitch of the first heat transmission member 220 of the first module 200 to the pitch P2 of the second heat transmission member 320 of the second module 300 may range from 1∼1.4:1.

Also, a volume of the first module 200 may be formed less than a volume of the second module 300. In particular, in this case, a plane area occupied by the heat absorbing module corresponding to the first module may be formed in the range of 5 to 50% with respect to a total plane area formed by the first module and the second module. When the area of the heat absorbing module is less than 5%, a condensing process of the air is properly generated, so condensing efficiency is reduced. When the area of the heat absorbing module is more than 50%, part of the condensed air may not be discharged due to the delay in condensation.

More preferably, a ratio of the plane area (d1*e1) of the first module illustrated in FIG. 2 to the plane area (d2*e2) of the second module may range from 1:1 to 10. Also, the first module 200 and the second module 300 may be spaced apart from each other to have a maximum spaced distance d2. In order to ensure efficient transmission of the condensed air and to increase the drying efficiency using radiating by preventing re-condensation of the air, the maximum spaced distance d2 may range from 0.01 to 50.0 mm. When the maximum spaced distance d2 is less than 0.01 mm, since the heat absorbing parts and the heat emitting parts of the first module and the second module are formed to be adjacent to each other, temperature offsetting is generated from each adjacent portion, and thus cooling efficiency is reduced. When the maximum spaced distance d2 is more than 50.0 mm, most of the condensed air is dispersed so that transmission of the air to the second module is not efficiently performed. Also, in this case, an area ratio and a spaced distance d5 between the third module 400 and the second module 300 may be also formed to be identical to the ratio between the first module and the second module.

FIG. 7 illustrates the structure of a heat conversion device according to another embodiment of the present invention.

As described above, in the embodiment of the present invention, the structure having the folding structure (i.e., the structure in which the flow path pattern is formed) performing surface contact with air is applied as the heat transmission member. In this case, the first module (heat absorbing module) 200, the second module (heat emitting module) 300, and the third module (heat absorbing module) 400 are disposed so that air can be transmitted to a direction horizontal to air flow, and as a result, resistance to the flow path can be minimized, and the processes of cooling, drying, and condensing can be sequentially implemented.

In the embodiment of FIG. 7, a plurality of structures having a pin form rather than the heat transmission member having the structure as shown in FIG. 4 is applied as a heat absorbing member 230, and a heat emitting member 330. In such a case, the first module (heat absorbing module), the second module (heat emitting module), and the third module (heat absorbing module) are also disposed so that air can be transmitted to a direction horizontal to air flow. Thus, the heat conversion device capable of minimizing the resistance to the flow path is illustrated.

Of course, in the embodiment of this case, each volume of the heat absorbing members 230, 430, and the heat emitting member 330, which can be installed in the same area, is reduced compared to that of the heat transmission member of FIG. 4, and each size of the heat absorbing members 230, 430, and the heat emitting member 330 has a limit in disposing them in a fixed space. Due to this, even though heat conversion efficiency is slightly reduced, as described above, since the first module (heat absorbing module), the second module (heat emitting module), and the third module (heat absorbing module) are also disposed so that air can be transmitted to the direction horizontal to air flow, it is advantageous in that the resistance to the flow path can be minimized.

Also, even though it is not illustrated in FIG. 7, the heat conversion device may be implemented by combining any one structure of the first module, the second module and the third module with a structure to which the radiating pin structure described in the section regarding FIG. 7 is applied.

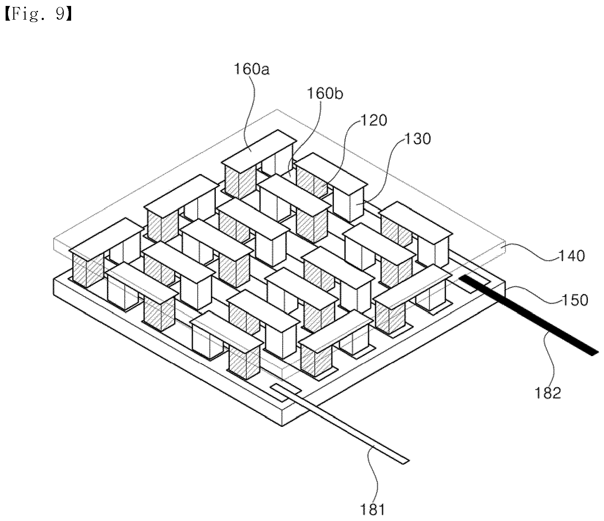

FIG. 8 illustrates a structure of the unit cell of the thermoelectric module including the thermoelectric element in contact with the first module and the second module, and FIG. 9 exemplarily illustrates the thermoelectric module in which the structure of FIG. 8 is disposed in plural number.

As illustrated in FIGS. 8 and 9, the thermoelectric module including the thermoelectric element according to the embodiment of the present invention may be configured to include at least one unit cell including the first substrate 140 and the second substrate 150 facing each other, the first semiconductor element 120 and the second semiconductor element 130 electrically connected to each other and disposed between the first substrate 140 and the second substrate 150. An insulating substrate, for example, an alumina substrate, may be used as the first substrate 140 and the second substrate 150. Also, according to the other embodiments, a metal substrate may be used so that heat absorbing and heat emitting efficiency and a slimming structure can be implemented. Of course, when the first substrate 140 and the second substrate are formed with the metal substrate, as illustrated in FIG. 8, dielectric layers 170a, 170b may be further formed between the first and second substrates and the electrode layers 160a, 160b formed at the first substrate 140 and the second substrate 150. In the structure described in the sections regarding FIG. 1, when a third substrate 210A and a fourth substrate 310B of the first module 200 and the second module 300 are integrally implemented with the first substrate and the second substrate, a material such as alumina, Cu, a Cu alloy, and the like may be applied to the substrates.

In the case of a metal substrate, Cu or a Cu alloy may be applied as the material of the substrate. A thickness of the substrate may be range from 0.1 to 0.5 mm so that a slimming structure can be realized. When the thickness of the metal substrate is less than 0.1 mm or more than 0.5 mm, since a radiating property is excessively increased, or heat conductivity becomes very high, reliability of the thermoelectric module is largely reduced. Also, in the case of the dielectric layers 170a, 170b, a material having a heat conductivity of 5 to 10 W/K may be used in consideration of the heat conductivity of the cooling thermoelectric module, and a thickness of the dielectric layer may range from 0.01 to 0.15 mm. In this case, when the thickness is less than 0.01 mm, insulating efficiency (or a withstanding voltage property) is largely reduced, and when the thickness is more than 0.15 mm, heat conductivity is reduced, and thus radiating efficiency is reduced. The electrode layers 160a, 160b electrically connect the first semiconductor element and the second semiconductor element using an electrode material such as Cu, Ag, Ni, and the like. When the illustrated unit cells are connected, as illustrated in FIG. 9, the electrode layers result in an electrical connection with the adjacent unit cell. A thickness of the electrode pattern may range from 0.01 to 0.3 mm. When the thickness of the electrode pattern is less than 0.01 mm, a function of the electrode pattern as an electrode is reduced, thereby causing a reduction of electric conductivity. Also, when the thickness of the electrode pattern is more than 0.3 mm, electric conductivity is also reduced due to an increase of resistance.

In particular, with regard to the thermoelectric elements forming unit cells, thermoelectric elements including unit elements having a laminated structure according to the one embodiment of the present invention may be applied. In this case, one surface of the thermoelectric element may be composed of a P-type semiconductor as the first semiconductor element 120 and an N-type semiconductor as the second semiconductor element 130. The first semiconductor and the second semiconductor are connected to the metal electrodes 160a, 160b. Such a structure is formed in plural number, and the Peltier effect is implemented by circuit lines 181, 182 for supplying electric current to the semiconductor element by means of the electrodes.

Moreover, in FIGS. 8 and 9, a P-type semiconductor or N-type semiconductor material may be applied to the semiconductor elements in the thermoelectric module in FIGS. 8 and 9. With regard to the P-type semiconductor or the N-type semiconductor material, the N-type semiconductor element may be formed using a mixture in which a main raw material based on BiTe containing Se, Ni, Al, Cu, Ag, Pb, B, Ga, Te, Bi, and In is mixed with 0.001 to 1.0 wt% of Bi or Te based on a total weight of the main raw material. For example, when the main raw material is a Bi-Se-Te based material, Bi or Te may be added in an amount of 0.001 to 1.0 wt% based on the total weight of the Bi-Se-Te material. That is, when the Bi-Se-Te based material is added in an amount of 100 g, the amount of Bi or Te additionally mixed therewith may range from 0.001 to 1.0 g. As described above, when the amount of the material added to the main raw material ranges from 0.001 to 0.1 wt%, heat conductivity is not reduced, and electric conductivity is reduced. Thus, the numerical range has a meaning in that the increase of a ZT value cannot be expected.

The P-type semiconductor element may be formed using a mixture in which a main raw material based on BiTe containing Sb, Ni, Al, Cu, Ag, Pb, B, Ga, Te, Bi, and In is mixed with 0.001 to 1.0 wt% of Bi or Te based on a total weight of the main raw material. For example, when the main raw material is a Bi-Se-Te based material, Bi or Te may be added in an amount of 0.001 to 1.0 wt% based on the total weight of the Bi-Se-Te material. That is, when the Bi-Se-Te based material is added in an amount of 100 g, the amount of Bi or Te additionally mixed therewith may range from 0.001 to 1.0 g. As described above, when the amount of the material added to the main raw material ranges from 0.001 to 0.1 wt%, heat conductivity is not reduced, and electric conductivity is reduced. Thus, the numerical range has a meaning in that the increase of a ZT value cannot be expected.

The first semiconductor element and the second semiconductor element facing each other while forming unit cells may have the same shape and size. However, in this case, since electric conductivity of the P-type semiconductor element is different from that of the n-type semiconductor element, cooling efficiency is reduced. In consideration of this fact, any one of them may be formed to have a volume different from that of the other semiconductor element so that a cooling ability can be improved.

That is, the volumes of the semiconductor elements of the unit cells disposed to face each other may be formed different from each other in such a manner that the semiconductor elements are entirely formed to have different shapes, a cross section of any one of the semiconductor elements having the same height is formed to have a diameter wider than that of a cross section of another one, or the semiconductor elements having the same shape are formed to have different heights and different diameters of each cross section. In particular, a diameter of the N-type semiconductor element is formed larger than that of the P-type semiconductor element in order to cause the increase of a volume, so that thermoelectric efficiency can be improved.

The heat conversion device according to the embodiment of the present invention may create air, which can be adjusted to a low temperature, while finally minimizing moisture by applying the heat emitting and absorbing effects realized by the thermoelectric module to the arrangement structure of the first module, the second module, and the third module, and by performing condensing, drying and re-condensing processes. Accordingly, when the heat conversion device is applied to a head lamp for a vehicle, the problem of a reduction in efficiency of an LED generated due to an increase in a temperature in a closed space can be solved.

Furthermore, when the heat conversion device according to the embodiment of the present invention is used in a dehumidifier, a temperature increase in indoor air in summer is prevented so that a dehumidifying effect and a cooling effect can be implemented.

As such, the heat conversion device according to the embodiment of the present invention may be very widely and commonly applied to various kinds of industrial equipment and various household electric appliances including a washing machine, a dehumidifier, a refrigerator, and the like.

As set forth above, according to some embodiments of the present invention, in the structure of a heat exchanger to which the thermoelectric module is applied, the heat conversion device capable of performing the condensing, drying and re-condensing processes of inflowing air is provided so that a temperature of the dried air can be controlled, and the air can be discharged in a state of being maintained at a desired temperature.

In particular, according to some embodiments of the present invention, the heat absorbing effect and the heat emitting effect can be implemented by the first module, the second module and the third module via the thermoelectric module. The pair of the cooling modules and one drying module are disposed in a horizontal direction so that a desired air volume and wind speed can be maintained without resistance to an air flow path, and a heat conversion effect for air can be implemented, and a heat conversion function having high efficiency can be implemented even under low power consumption.

Also, the absorbing modules and the heat emitting module are disposed in the heat conversion member coming into surface contact with air and having a folding structure while forming a plurality of flow paths so that a contact area with the air can be maximized and heat conversion efficiency can be largely improved.

Furthermore, friction with the air at a curvature surface of the unit heat conversion part of the heat conversion member can be increased, and heat conversion efficiency can be further increased by forming the patterns having the structure in which the resistance patterns for enabling an increase of air circulation and the flow path grooves are combined.

Also, thanks to the heat conversion member having the folding structure, the heat conversion device having high efficiency can be formed regardless of a limited area of a heat exchanger, and a widely used design arrangement can be implemented by forming the product to be small in volume.

As previously described, in the detailed description of the invention, having described the detailed exemplary embodiments of the invention, it should be apparent that modifications and variations can be made by persons skilled without deviating from the scope of the invention. Therefore, it is to be understood that the foregoing is illustrative of the present invention and is not to be construed as limited to the specific embodiments disclosed, and that modifications to the disclosed embodiments, as well as other embodiments, are intended to be included within the scope of the appended claims.

## Claims

1. A heat conversion device, comprising:
a thermoelectric module (100) including
a first heat conversion part which comprises a first substrate (140),
a second heat conversion part which comprises a second substrate (150), and
a thermoelectric semiconductor (120) between the first substrate (140) and the second substrate (150) facing each other;
a first module (200) comprising a first heat transmission member (220) and contacting with the first heat conversion part,
a second module (300) comprising a second heat transmission member (320) and contacting with the second heat conversion part, and
a third module (400) comprising a third heat transmission member (420) and contacting with the first heat conversion part,
wherein the first module (200) is configured to convert a temperature of inflowing air using a heat conversion function of the thermoelectric module (100);
the second module (300) is configured to reconvert the temperature of the air passing through the first module (200); and
the third module (400) is configured to control the temperature of the air passing through the second module (300).

2. The heat conversion device of claim 1, wherein the first substrate (140) is a heat absorbing substrate.

3. The heat conversion device of claims 1 or 2, wherein the second substrate (150) is a heat emitting substrate.

4. The heat conversion device of any one of claims 1 to 3, wherein the first module (200), the second module (300), and the third module (400) are disposed in one side direction based on the thermoelectric module (100), the one side direction being defined as any one direction of an upwards direction and a downwards direction of the thermoelectric module (100).

5. The heat conversion device of any one of claims 1 to 4, wherein the second module (300) is disposed at a lower portion of the second substrate (150) of the thermoelectric module (100), and the first module (200) and the second module (300) are disposed at both sides of the thermoelectric module (100).

6. The heat conversion device of any one of claims 1, 2, 3 and 5, wherein the first module (200), the second module (300), and the third module (400) are spaced apart from one another, and a spaced distance between the first module (200) and the second module (300) ranges from 0.01 to 50.0 mm.

7. The heat conversion device of any one of claims 1 2, 3 and 6, wherein at least one of the first module (200), the second module (300), and the third module (400) further comprises: a heat transmission substrate in contact with the first substrate (140) or the second substrate (150) of the thermoelectric module (100); and a heat transmission member in contact with inflowing air.

8. The heat conversion device of claim 7, wherein the heat transmission member comprises: a radiating substrate having a first plane (221) in surface contact with air, and a second plane (222) opposite to the first plane (221); and at least one flow path pattern forming an air flow path in the radiating substrate in an air flowing direction.

9. The heat conversion device of claim 8, wherein the flow path pattern has a structure in which a curvature pattern having a fixed pitch is implemented in a lengthwise direction of the radiating substrate.

10. The heat conversion device of claim 8 or 9, further comprising a resistance pattern (223) formed on a surface of the flow path pattern and protruding from a surface of the radiating substrate.

11. The heat conversion device of claim 7, wherein the heat transmission member comprises a plurality of radiating pins formed on the radiating substrate and protruding in the one side direction.

## Patentansprüche

1. Wärmeumwandlungsvorrichtung, umfassend:
ein thermoelektrisches Modul (100), aufweisend
ein erstes Wärmeumwandlungsteil, das ein erstes Substrat (140) umfasst,
ein zweites Wärmeumwandlungsteil, das ein zweites Substrat (150) umfasst, und
einen thermoelektrischen Halbleiter (120) zwischen dem ersten Substrat (140) und dem zweiten Substrat (150), die einander zugewandt sind;
ein erstes Modul (200), das ein erstes Wärmeübertragungselement (220) umfasst und mit dem ersten Wärmeumwandlungsteil in Kontakt tritt,
ein zweites Modul (300), das ein zweites Wärmeübertragungselement (320) umfasst und mit dem zweiten Wärmeumwandlungsteil in Kontakt tritt, und
ein drittes Modul (400), das ein drittes Wärmeübertragungselement (420) umfasst und
mit dem ersten Wärmeumwandlungsteil in Kontakt tritt,
wobei das erste Modul (200) konfiguriert ist, um eine Temperatur von einströmender Luft unter Verwendung einer Wärmeumwandlungsfunktion des thermoelektrischen Moduls (100) umzuwandeln;
das zweite Modul (300) konfiguriert ist, um die Temperatur der Luft, die das erste Modul (200) durchläuft, zurückzuverwandeln; und
das dritte Modul (400) konfiguriert ist, um die Temperatur der Luft, die das zweite Modul (300) durchläuft, zu steuern.

2. Wärmeumwandlungsvorrichtung nach Anspruch 1, wobei das erste Substrat (140) ein wärmeabsorbierendes Substrat ist.

3. Wärmeumwandlungsvorrichtung nach einem der Ansprüche 1 oder 2, wobei das zweite Substrat (150) ein wärmeemittierndes Substrat ist.

4. Wärmeumwandlungsvorrichtung nach einem der Ansprüche 1 bis 3, wobei das erste Modul (200), das zweite Modul (300) und das dritte Modul (400) in einer Seitenrichtung basierend auf dem thermoelektrischen Modul (100) angeordnet sind, wobei die eine Seitenrichtung als eine beliebige Richtung einer Aufwärtsrichtung und einer Abwärtsrichtung des thermoelektrischen Moduls (100) definiert ist.

5. Wärmeumwandlungsvorrichtung nach einem der Ansprüche 1 bis 4, wobei das zweite Modul (300) an einem unteren Abschnitt des zweiten Substrats (150) des thermoelektrischen Moduls (100) angeordnet ist und das erste Modul (200) und das zweite Modul (300) an beiden Seiten des thermoelektrischen Moduls (100) angeordnet sind.

6. Wärmeumwandlungsvorrichtung nach einem der Ansprüche 1, 2, 3 und 5, wobei das erste Modul (200), das zweite Modul (300) und das dritte Modul (400) voneinander beabstandet sind und ein räumlicher Abstand zwischen dem ersten Modul (200) und dem zweiten Modul (300) im Bereich von 0,01 bis 50,0 mm liegt.

7. Wärmeumwandlungsvorrichtung nach einem der Ansprüche 1, 2, 3 und 6, wobei mindestens eines von dem ersten Modul (200), dem zweiten Modul (300) und dem dritten Modul (400) ferner umfasst: ein Wärmeübertragungssubstrat in Kontakt mit dem ersten Substrat (140) oder dem zweiten Substrat (150) des thermoelektrischen Moduls (100); und ein Wärmeübertragungselement in Kontakt mit einströmender Luft.

8. Wärmeumwandlungsvorrichtung nach Anspruch 7, wobei das Wärmeübertragungselement umfasst: ein Strahlungssubstrat mit einer ersten Fläche (221) in Oberflächenkontakt mit Luft und einer zweiten Fläche (222) gegenüber der ersten Fläche (221); und mindestens ein Strömungswegmuster, das einen Luftströmungsweg in dem Strahlungssubstrat in einer Luftströmungsrichtung bildet.

9. Wärmeumwandlungsvorrichtung nach Anspruch 8, wobei das Strömungswegmuster eine Struktur aufweist, in der ein Krümmungsmuster mit einem festen Abstand in einer Längsrichtung des Strahlungssubstrats implementiert ist.

10. Wärmeumwandlungsvorrichtung nach Anspruch 8 oder 9, ferner umfassend ein Widerstandsmuster (223), das auf einer Oberfläche des Strömungswegmusters ausgebildet ist und von einer Oberfläche des Strahlungssubstrats vorsteht.

11. Wärmeumwandlungsvorrichtung nach Anspruch 7, wobei das Wärmeübertragungselement eine Mehrzahl von Strahlungsstiften umfasst, die auf dem Strahlungssubstrat ausgebildet sind und in der einen Seitenrichtung vorstehen.

## Revendications

1. Dispositif de conversion de chaleur, comprenant :
un module thermoélectrique (100) comportant
une première partie de conversion de chaleur qui comprend un premier substrat (140),
une seconde partie de conversion de chaleur qui comprend un second substrat (150) et
un semi-conducteur thermoélectrique (120) entre le premier substrat (140) et le second substrat (150) tournés l'un vers l'autre ;
un premier module (200) comprenant un premier élément de transmission de chaleur (220) et se trouvant en contact avec la première partie de conversion de chaleur,
un deuxième module (300) comprenant un deuxième élément de transmission de chaleur (320) et se trouvant en contact avec la seconde partie de conversion de chaleur, et
un troisième module (400) comprenant un troisième élément de transmission de chaleur (420) et se trouvant en contact avec la première partie de conversion de chaleur,
dans lequel le premier module (200) est configuré pour convertir une température de l'air entrant au moyen d'une fonction de conversion de chaleur du module thermoélectrique (100) ;
le deuxième module (300) est configuré pour reconvertir la température de l'air traversant le premier module (200) ; et
le troisième module (400) est configuré pour commander la température de l'air traversant le deuxième module (300).

2. Dispositif de conversion de chaleur selon la revendication 1, dans lequel le premier substrat (140) est un substrat d'absorption de chaleur.

3. Dispositif de conversion de chaleur selon la revendication 1 ou 2, dans lequel le second substrat (150) est un substrat d'émission de chaleur.

4. Dispositif de conversion de chaleur selon l'une quelconque des revendications 1 à 3, dans lequel le premier module (200), le deuxième module (300) et le troisième module (400) sont disposés dans une direction latérale sur la base du module thermoélectrique (100), ladite direction latérale étant définie comme une quelconque direction d'une direction vers le haut et d'une direction vers le bas du module thermoélectrique (100).

5. Dispositif de conversion de chaleur selon l'une quelconque des revendications 1 à 4, dans lequel le deuxième module (300) est disposé au niveau d'une partie inférieure du second substrat (150) du module thermoélectrique (100), et le premier module (200) et le deuxième module (300) sont disposés sur les deux côtés du module thermoélectrique (100).

6. Dispositif de conversion de chaleur selon l'une quelconque des revendications 1, 2, 3 et 5, dans lequel le premier module (200), le deuxième module (300) et le troisième module (400) sont séparés les uns des autres, et une distance d'espacement entre le premier module (200) et le deuxième module (300) est compris dans la plage de 0,01 à 50,0 mm.

7. Dispositif de conversion de chaleur selon l'une quelconque des revendications 1, 2, 3 et 6, dans lequel au moins un parmi le premier module (200), le deuxième module (300) et le troisième module (400) comprend en outre : un substrat de transmission de chaleur en contact avec le premier substrat (140) ou le second substrat (150) du module thermoélectrique (100) ; et un élément de transmission de chaleur en contact avec l'air entrant.

8. Dispositif de conversion de chaleur selon la revendication 7, dans lequel l'élément de transmission de chaleur comprend : un substrat de rayonnement ayant un premier plan (221) en contact de surface avec l'air et un second plan (222) en face du premier plan (221) ; et au moins un motif de voie d'écoulement formant une voie d'écoulement d'air dans le substrat de rayonnement dans une direction d'écoulement d'air.

9. Dispositif de conversion de chaleur selon la revendication 8, dans lequel le motif de voie d'écoulement présente une structure dans laquelle un motif de courbure ayant un pas fixe est appliqué dans une direction longitudinale du substrat de rayonnement.

10. Dispositif de conversion de chaleur selon la revendication 8 ou 9, comprenant en outre un motif de résistance (223) formé sur une surface du motif de voie d'écoulement et faisant saillie à partir d'une surface du substrat de rayonnement.

11. Dispositif de conversion de chaleur selon la revendication 7, dans lequel l'élément de transmission de chaleur comprend une pluralité d'ergots de rayonnement formés sur le substrat de rayonnement et faisant saillie dans l'une direction latérale.
